# EUROPEAN PATENT APPLICATION

(11) **EP 1 916 710 A1**
(43) Date of publication of application: **30.04.2008**
(21) Application number: 07020815.2
(22) Date of filing: 24.10.2007
(51) Int. Cl.: H01L 21/8247, H01L 27/115

(54) **Nonvolatile semiconductor memory device and method of producing the same**

(30) Priority: 26.10.2006 JP 2006291627
(71) Applicant: Renesas Technology Corp., Tokyo 100-0004 (JP)
(72) Inventor: Ishii, Motoharu, Itami-shi Hyogo 664-0005 (JP); Sakakibara, Kiyohiko, Chiyoda-ku Tokyo 100-0004 (JP)
(74) Representative: Klein, Peter

(57) **Abstract**

A nonvolatile semiconductor memory device includes a semiconductor substrate (SB) having a principal surface, memory transistors (MT), and selection transistors (ST). Each of the memory transistors (MT) has a floating gate (FG) and a control gate (CG) that are formed by lamination with each other on the principal surface. Each of the selection transistors (ST) has a lower gate layer (G2) and an upper gate layer (G1) that are formed by lamination with each other on the principal surface, and is contained in a memory cell (MC) together with one of the memory transistors (MS). The lower gate layer (G2) is separated for each one of the selection transistors (ST). The upper gate layer (G1) is owned commonly by the selection transistors (ST) and is electrically connected to the lower gate layer (G2) of each of the selection transistors (ST). Therefore, it is possible to prevent short-circuiting of the selection transistors (ST) and the memory transistors (MT).

## Description

### BACKGROUND OF THE INVENTION

### Field of the Invention

The present invention relates to a nonvolatile semiconductor memory device and a method of producing the same. More particularly, the present invention relates to a nonvolatile semiconductor memory device having a floating gate and a control gate, as well as a method of producing the same.

### Description of the Background Art

A memory cell of a nonvolatile semiconductor memory device may have a floating gate transistor (memory transistor) and a separation transistor (selection transistor) that are connected with each other in series. The floating gate transistor (memory transistor) may have a floating gate and a control gate. Also, the separation transistor (selection transistor) may have a separation gate (selection gate).

A plurality of separation transistors (selection transistors) have a separation gate (selection gate) in common. Therefore, the plurality of separation transistors (selection transistors) are turned on and off by control of the electric potential of one separation gate (selection gate).

When the separation transistor is turned off, the memory cells having this separation transistor (selection transistor) are separated from a source line. Therefore, whether the floating gate transistors (memory transistors) that these memory cells have are in a state of overerasure does not affect the reading of data. Thus, by the function of the separation transistor, the reading error caused by overerasure is prevented.

A method of producing the above-described nonvolatile semiconductor memory device includes the following steps. First, a tunnel dielectric layer is formed on a semiconductor substrate. Subsequently, a first electroconductive layer is formed on this insulating layer. Next, by the lithography method, a mask made of a photoresist is formed on this first electroconductive layer. Subsequently, by etching with use of this mask, a separation gate (selection gate) and a floating gate made of the first electroconductive layer are patterned simultaneously. Next, an interlayer dielectric layer (insulating layer) and a second electroconductive layer are formed over an entire surface of the semiconductor substrate. Subsequently, the second electroconductive layer is patterned so that the second electroconductive layer may remain only at the place of the floating gate transistor (memory transistor), so as to form a control gate.

Such a technique of forming a nonvolatile semiconductor memory device is disclosed, for example, in Japanese Patent Laying-Open No. 07-297304.

In the above-described conventional example, the separation gate (selection gate) is formed by a film of one layer made of the first electroconductive layer. In order that this separation gate (selection gate) may be owned by a plurality of separation transistors (selection transistors), the separation gate (selection gate) must be linearly patterned along an arrangement of the plurality of separation transistors.

For this reason, in forming the separation gate (selection gate) and the floating gate in the above-described step, the pattern of the opening of the mask used for etching must be a pattern that evades a region where the separation gate (selection gate) extends linearly. For this reason, the pattern of the opening cannot be made in a simple linear form, and will be a pattern having numerous end parts.

In a fine pattern forming technique, it is generally more difficult to form the end parts with a good precision than to form the middle part having a linear pattern. For this reason, in forming the pattern of the opening of the above-described mask, the size of the end part of the pattern of the opening may sometimes be larger than a desired one. When the first electroconductive layer is etched with use of such a mask, the first electroconductive layer is locally largely etched at the end part of the pattern of the opening.

When the interlayer dielectric layer (insulating layer) and the second electroconductive layer are formed on a recessed part that has been formed by being locally largely etched in this manner, there will be a large step difference on the film surface.

At this step difference part, foreign substances are liable to remain in the steps of producing a nonvolatile semiconductor memory device. When these foreign substances function as a mask in the etching step, the etching of the second electroconductive layer may become incomplete at a position between the floating gate transistor (memory transistor) and the separation transistor (selection transistor) that are adjacent to each other. This results in a problem such that a short circuit may be generated between the floating gate transistor (memory transistor) and the separation transistor (selection transistor).

### SUMMARY OF THE INVENTION

The present invention has been made in view of the above-described problems, and an object thereof is to provide a nonvolatile semiconductor memory device and a method of producing the same that can prevent short-circuiting of the memory transistor and the selection transistor caused by the foreign substances appearing in the production steps.

A nonvolatile semiconductor memory device according to one embodiment of the present invention includes a semiconductor substrate having a principal surface, a plurality of memory transistors, and a plurality of selection transistors. Each of the memory transistors has a floating gate and a control gate. The floating gate and a control gate are formed by lamination with each other on the principal surface. Each of the selection transistors has a lower gate layer and an upper gate layer. The lower gate layer and the upper gate layer are formed by lamination with each other on the principal surface. Each of the selection transistors is contained in a memory cell together with one of the memory transistors. The lower gate layer is separated for each of the selection transistors. The upper gate layer is owned commonly by the selection transistors and is electrically connected to the lower gate layer of each of the selection transistors.

A method of producing a nonvolatile semiconductor memory device according to one embodiment of the present invention is a method of producing a nonvolatile semiconductor memory device having a plurality of memory cells, and includes the following steps.

First, a first insulating layer is formed on a semiconductor substrate. A first electroconductive layer is formed on this first insulating layer. The first electroconductive layer is patterned into a plurality of band shapes so that each of the band shapes extends over a region where the plurality of memory cells are to be formed. A second insulating layer is formed on the first electroconductive layer. A plurality of openings are formed to expose a surface of the first electroconductive layer in the second insulating layer so that each of the openings is crossing the band shapes. A second electroconductive layer is formed so as to be electrically connected to the first electroconductive layer via the openings and to cover the second insulating layer. The second electroconductive layer and the first electroconductive layer are patterned so as to form a laminate pattern including a part of the first electroconductive layer and a part of the second electroconductive layer that are electrically insulated with each other by the second insulating layer, and to form a laminate pattern including a part of the first electroconductive layer and a part of the second electroconductive layer that are formed along the openings and electrically connected with each other at the openings.

With the nonvolatile semiconductor memory device and a method of producing the same according to this embodiment, the selection transistor has a lower gate layer and an upper gate layer. Then, the lower gate layer is separated for each one of the selection transistors, and is electrically connected to the upper gate layer that is owned commonly by the plurality of selection transistors. For this reason, there is no need to pattern the lower gate layer linearly along the plurality of selection transistors. Therefore, the opening of the mask for patterning the floating gate and the lower gate layer can be extended over the selection transistors as well. For this reason, the opening can be made linear, and one can avoid a state in which the opening has an end part in the midway portion of the memory cell array region. Therefore, foreign substances that are liable to be generated at the position where the end part of the opening was located can be prevented from remaining. This can prevent short-circuiting between the memory transistor and the selection transistor caused by influence of the foreign substances on the etching step at the time of producing the nonvolatile semiconductor memory device.

The foregoing and other objects, features, aspects and advantages of the present invention will become more apparent from the following detailed description of the present invention when taken in conjunction with the accompanying drawings.

### BRIEF DESCRIPTION OF THE DRAWINGS

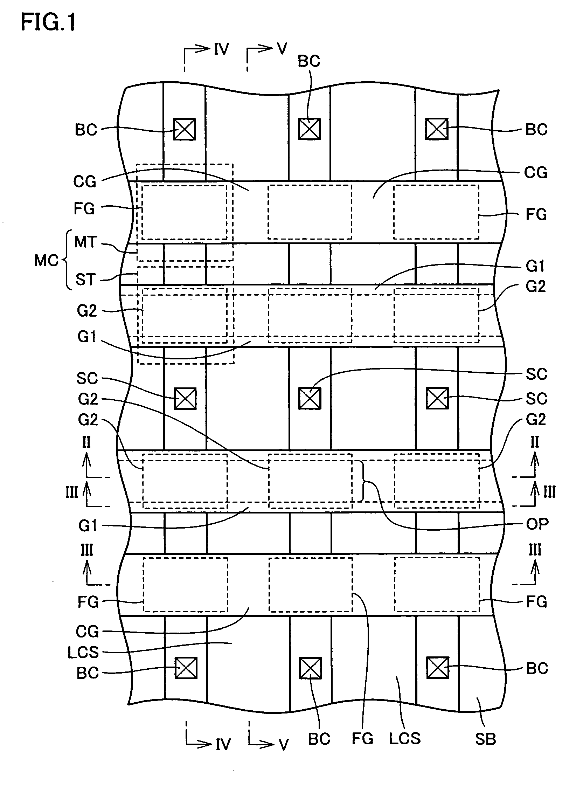

Fig. 1 is a schematic plan view showing a plan layout within a memory cell array of a nonvolatile semiconductor memory device according to the Embodiment 1 of the present invention;

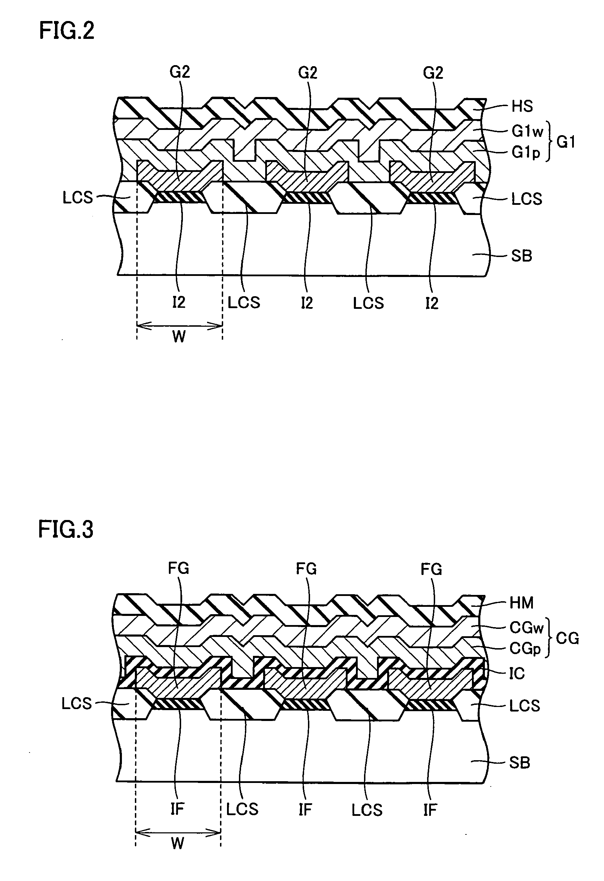

Figs. 2 to 5 are schematic cross-sectional views corresponding to the line II-II, the line III-III, the line IV-IV, and the line V-V in Fig. 1;

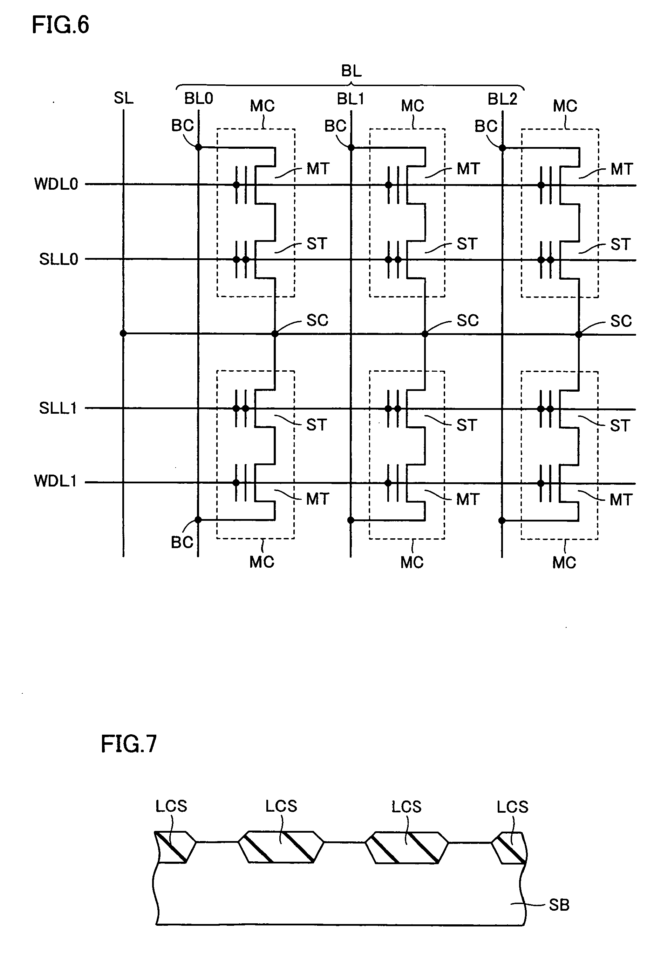

Fig. 6 is a circuit diagram showing a model circuit construction of the nonvolatile semiconductor memory device according to Embodiment 1 of the present invention;
Figs. 7 to 16 are schematic cross-sectional views sequentially showing the first to tenth steps in a method of producing the nonvolatile semiconductor memory device according to Embodiment 1 of the present invention, wherein the cross-sectional positions in these drawings correspond to the positions along any one of the line II-II and the line III-III in Fig. 1;

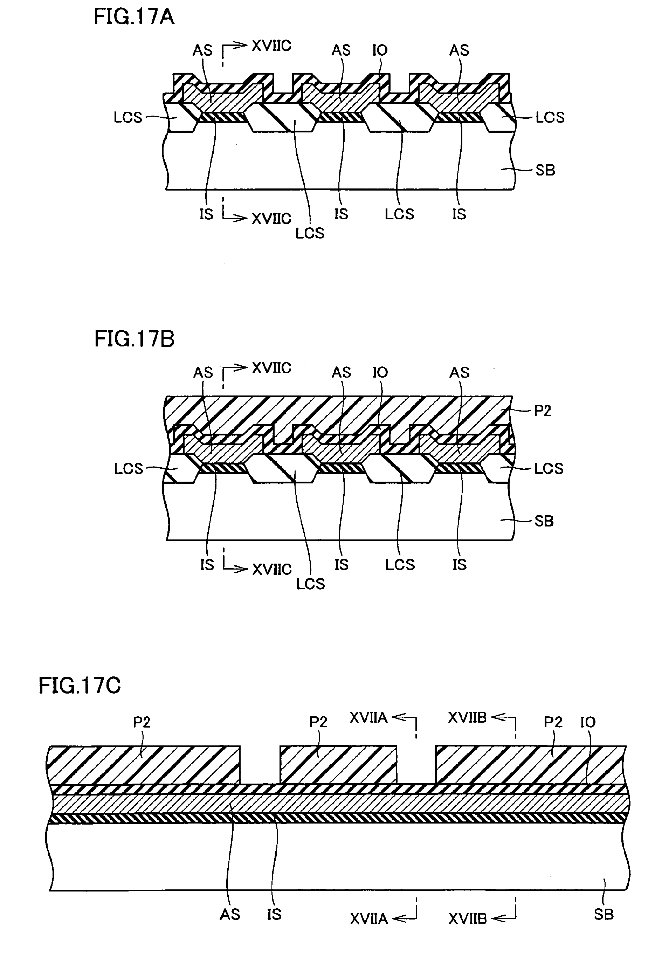

Figs. 17A to 17C are schematic cross-sectional views sequentially showing the eleventh step in a method of producing the nonvolatile semiconductor memory device according to the Embodiment 1 of the present invention, wherein the respective cross-sectional positions in these drawings correspond to the positions along the line II-II, the line III-III, and the line IV-IV in Fig. 1, respectively;

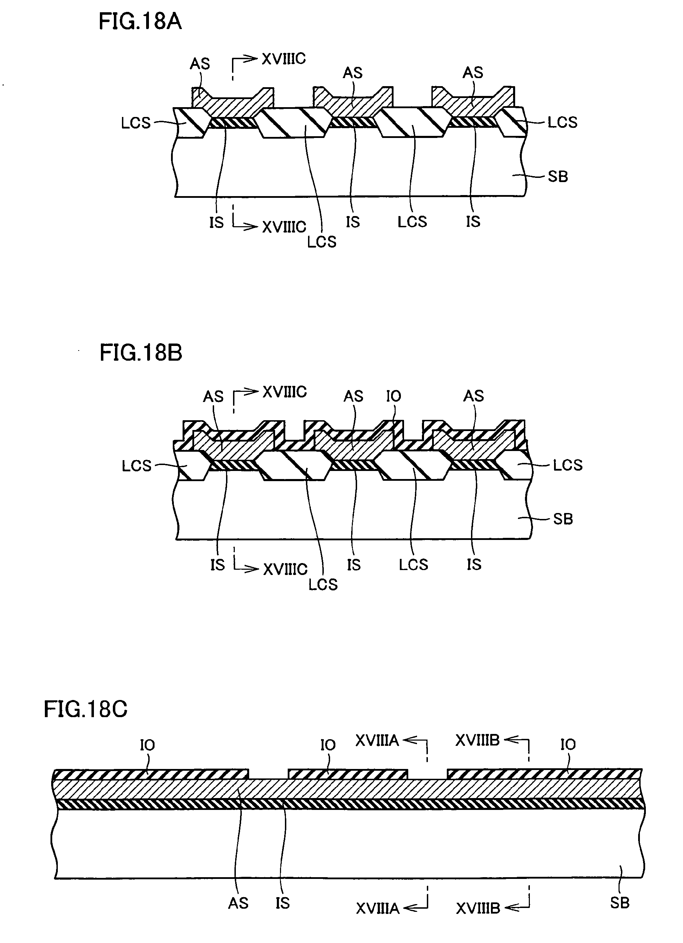

Figs. 18A to 18C are schematic cross-sectional views sequentially showing the twelfth step in the method of producing the nonvolatile semiconductor memory device according to the Embodiment 1 of the present invention, wherein the respective cross-sectional positions in these drawings correspond to the positions along the line II-II, the line III-III, and the line IV-IV in Fig. 1, respectively;

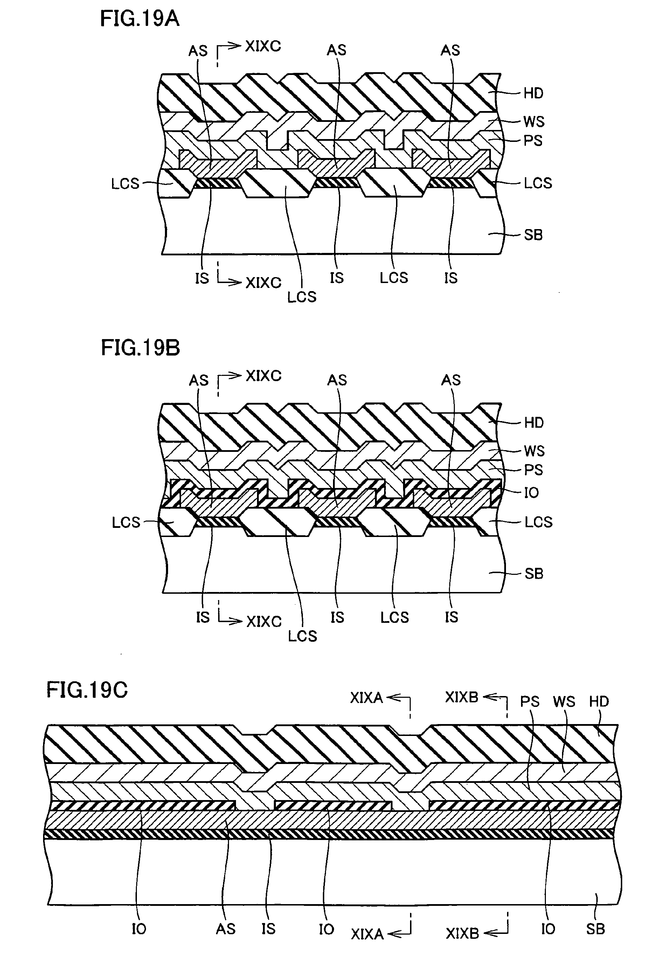

Figs. 19A to 19C are schematic cross-sectional views sequentially showing the thirteenth step in the method of producing the nonvolatile semiconductor memory device according to Embodiment 1 of the present invention, wherein the respective cross-sectional positions in these drawings correspond to the positions along the line II-II, the line III-III, and the line IV-IV in Fig. 1, respectively;

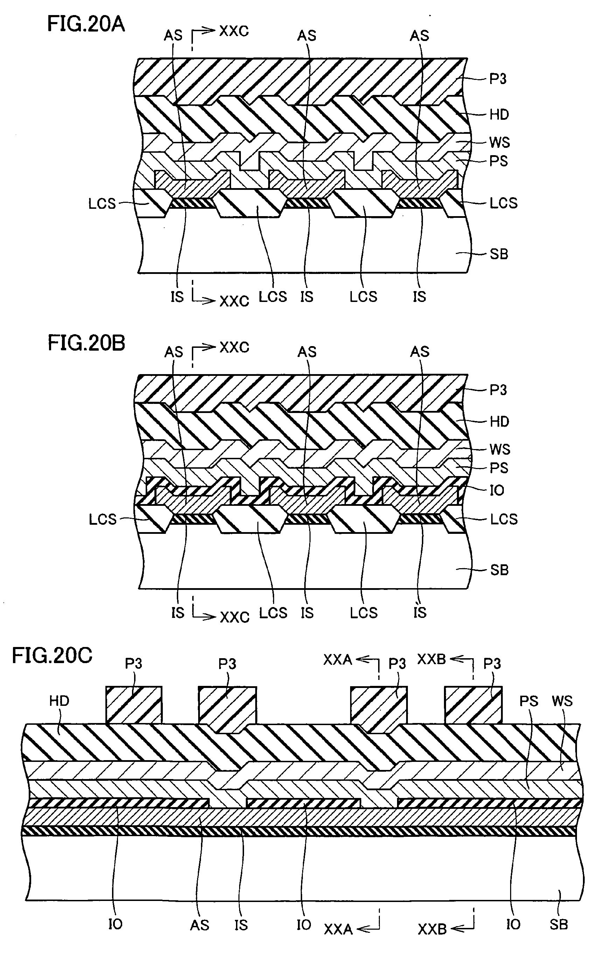

Figs. 20A to 20C are schematic cross-sectional views sequentially showing the fourteenth step in the method of producing the nonvolatile semiconductor memory device according to Embodiment 1 of the present invention, wherein the respective cross-sectional positions in these drawings correspond to the positions along the line II-II, the line III-III, and the line IV-IV in Fig. 1, respectively;

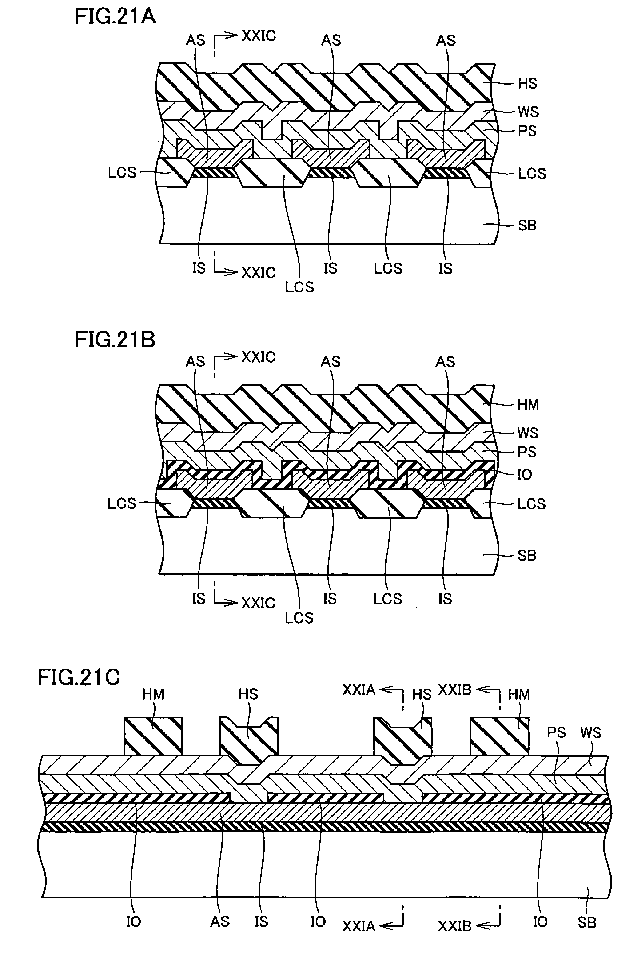

Figs. 21A to 21C are schematic cross-sectional views sequentially showing the fifteenth step in the method of producing the nonvolatile semiconductor memory device according to Embodiment 1 of the present invention, wherein the respective cross-sectional positions in these drawings correspond to the positions along the line II-II, the line III-III, and the line IV-IV in Fig. 1, respectively;

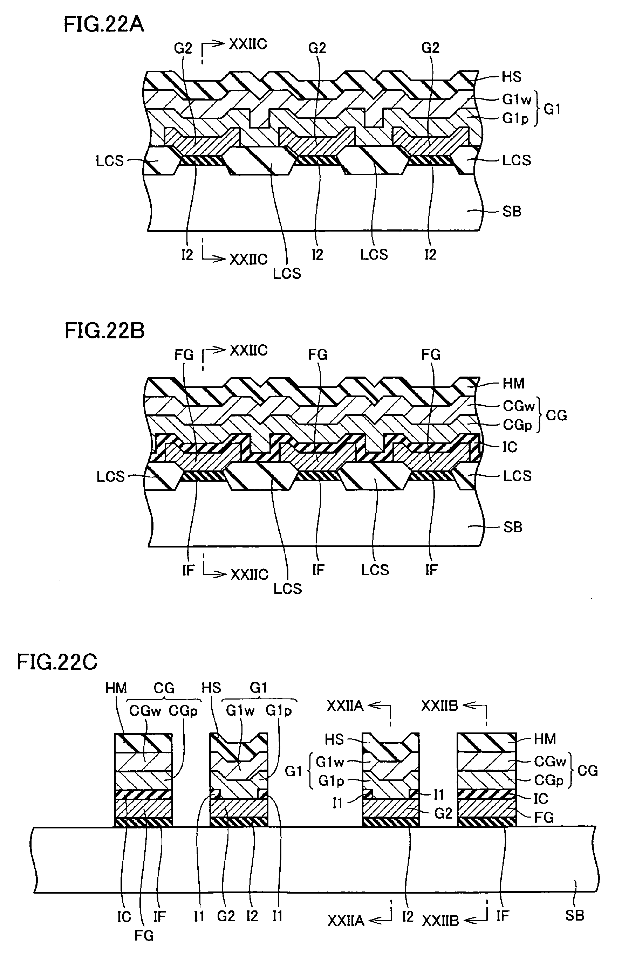

Figs. 22A to 22C are schematic cross-sectional views sequentially showing the sixteenth step in the method of producing the nonvolatile semiconductor memory device according to the Embodiment 1 of the present invention, wherein the respective cross-sectional positions in these drawings correspond to the positions along the line II-II, the line III-III, and the line IV-IV in Fig. 1, respectively;

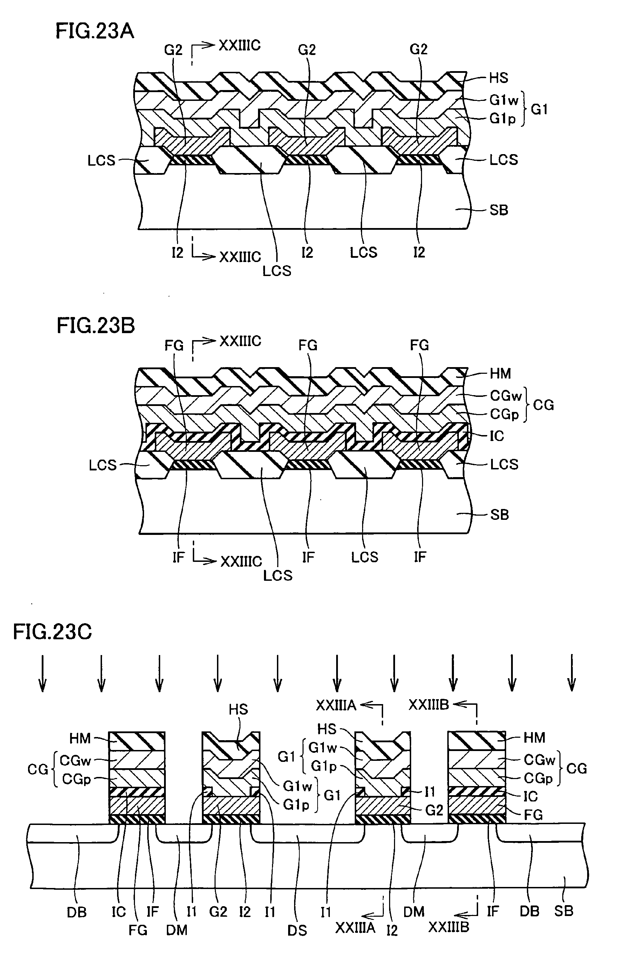

Figs. 23A to 23C are schematic cross-sectional views sequentially showing the seventeenth step in the method of producing the nonvolatile semiconductor memory device according to the Embodiment 1 of the present invention, wherein the respective cross-sectional positions in these drawings correspond to the positions along the line II-II, the line III-III, and the line IV-IV in Fig. 1, respectively;

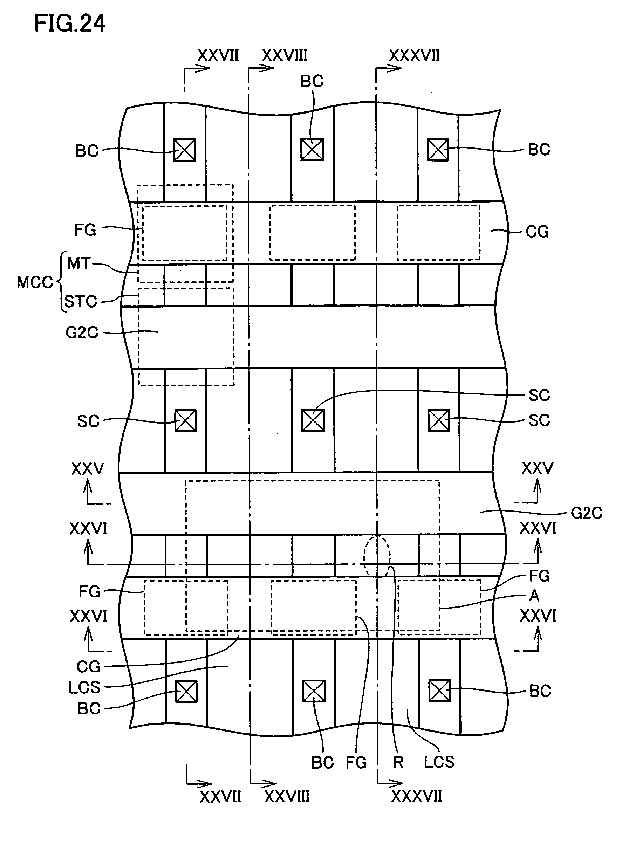

Fig. 24 is a schematic plan view showing a plan layout within a memory cell array of a nonvolatile semiconductor memory device in a Comparative Example;

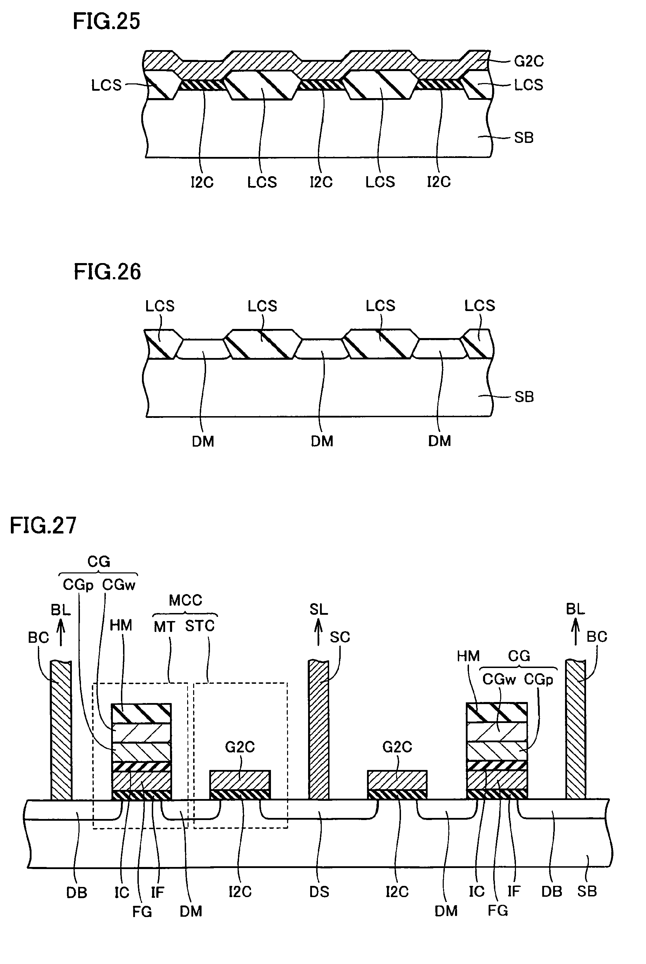

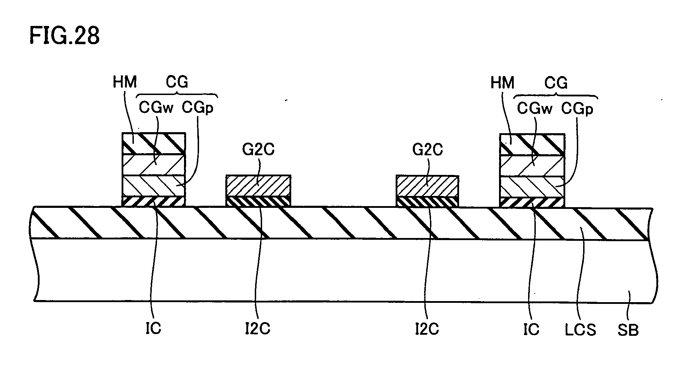

Figs. 25 to 28 are schematic cross-sectional views along the line XXV-XXV, the line XXVI-XXVI, the line XXVII-XXVII, and the line XVIII-XXVIII in Fig. 24, respectively;

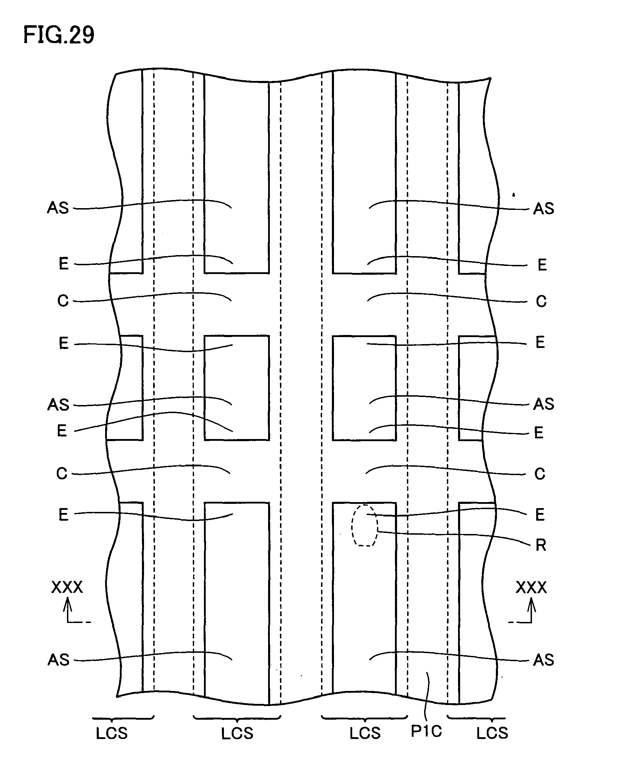

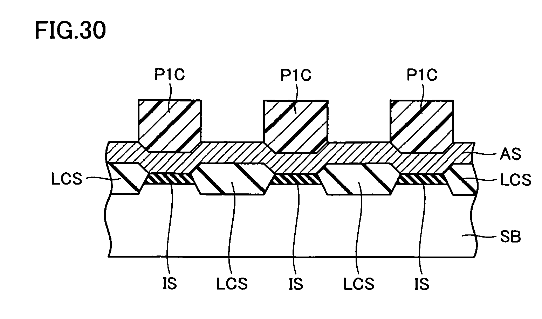

Figs. 29 and 30 are a schematic plan view and a schematic cross-sectional view showing the first step in the method of producing the nonvolatile semiconductor memory device of the Comparative Example, wherein the cross-sectional position in Fig. 30 corresponds to the position along the line XXX-XXX in Fig. 29;

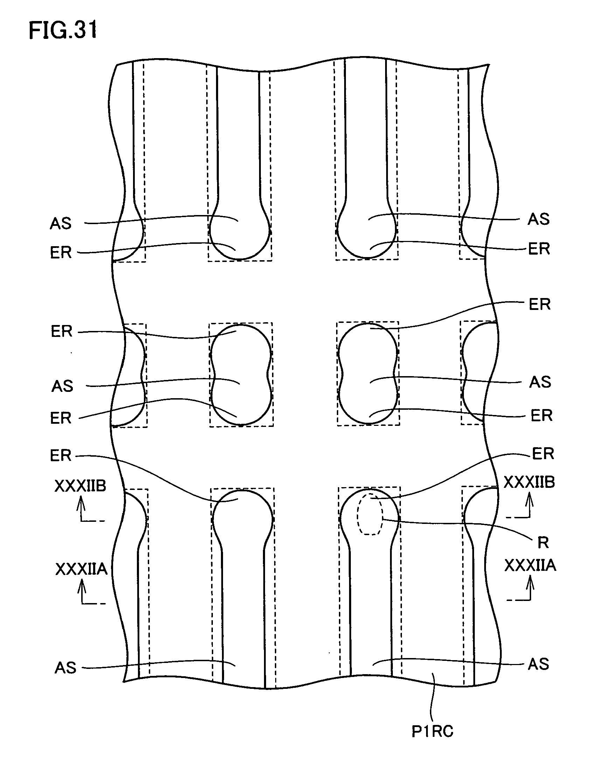

Fig. 31 is a schematic plan view showing the second step in the method of producing the nonvolatile semiconductor memory device of the Comparative Example;

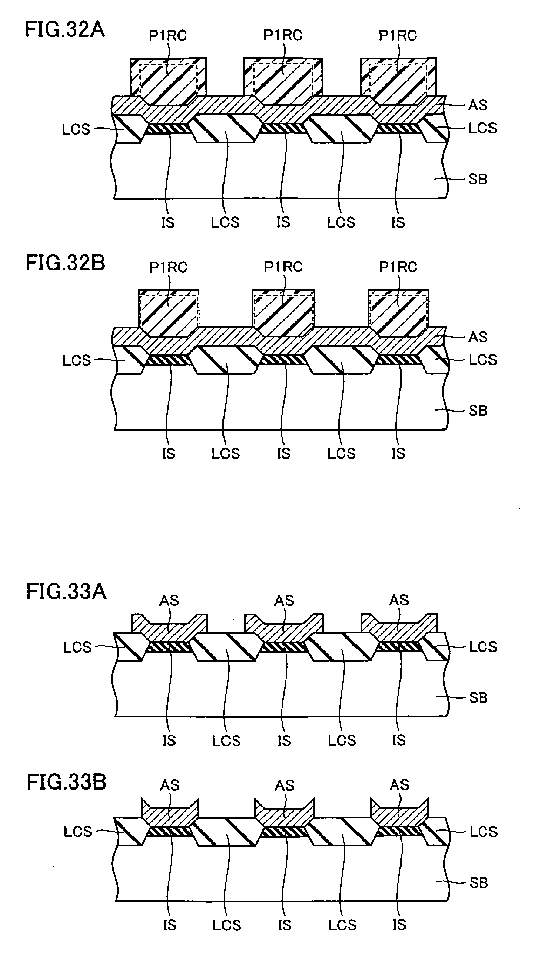

Figs. 32A and 32B are schematic cross-sectional views showing the second step in the method of producing the nonvolatile semiconductor memory device of the Comparative Example, wherein the respective cross-sectional positions in Figs. 32A and 32B correspond to the positions along the line XXXIIA-XXXlIA and the line XXXIIB-XXXIIB in Fig. 31, respectively;
Figs. 33A and 33B are schematic cross-sectional views showing the third step in the method of producing the nonvolatile semiconductor memory device of the Comparative Example, wherein the respective cross-sectional positions in Figs. 33A and 33B correspond to the positions along the line XXXIIA-XXXIIA and the line XXXIIB-XXXIIB in Fig. 31, respectively;

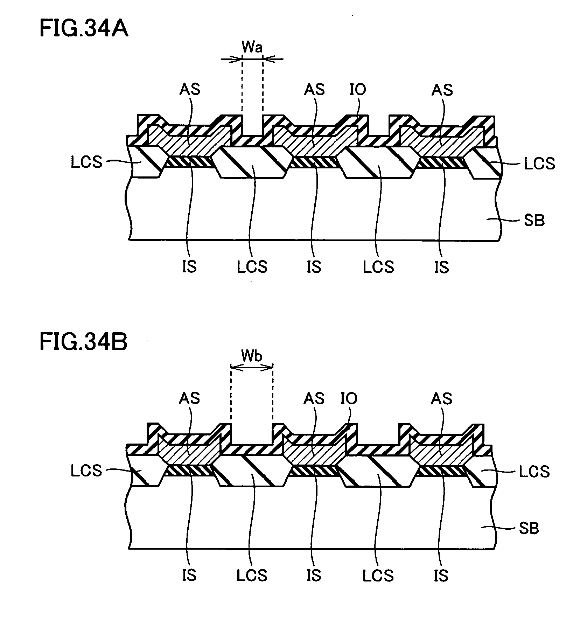

Figs. 34A and 34B are schematic cross-sectional views showing the fourth step in the method of producing the nonvolatile semiconductor memory device of the Comparative Example, wherein the respective cross-sectional positions in Figs. 34A and 34B correspond to the positions along the line XXXIIA-XXXIIA and the line XXXIIB-XXXIIB in Fig. 31, respectively;

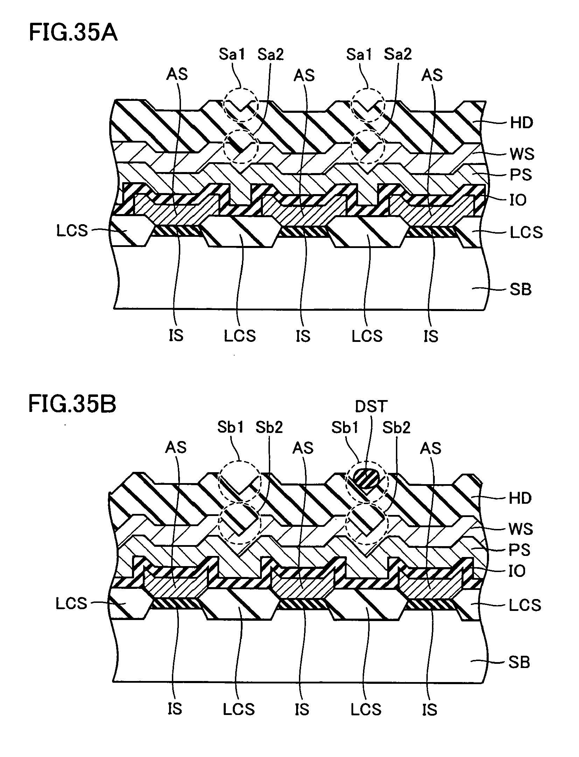

Figs. 35A and 35B are schematic cross-sectional views showing the fifth step in the method of producing the nonvolatile semiconductor memory device of the Comparative Example, wherein the respective cross-sectional positions in Figs. 35A and 35B correspond to the positions along the line XXXIIA-XXXIIA and the line XXXIIB-XXXIIB in Fig. 31, respectively;

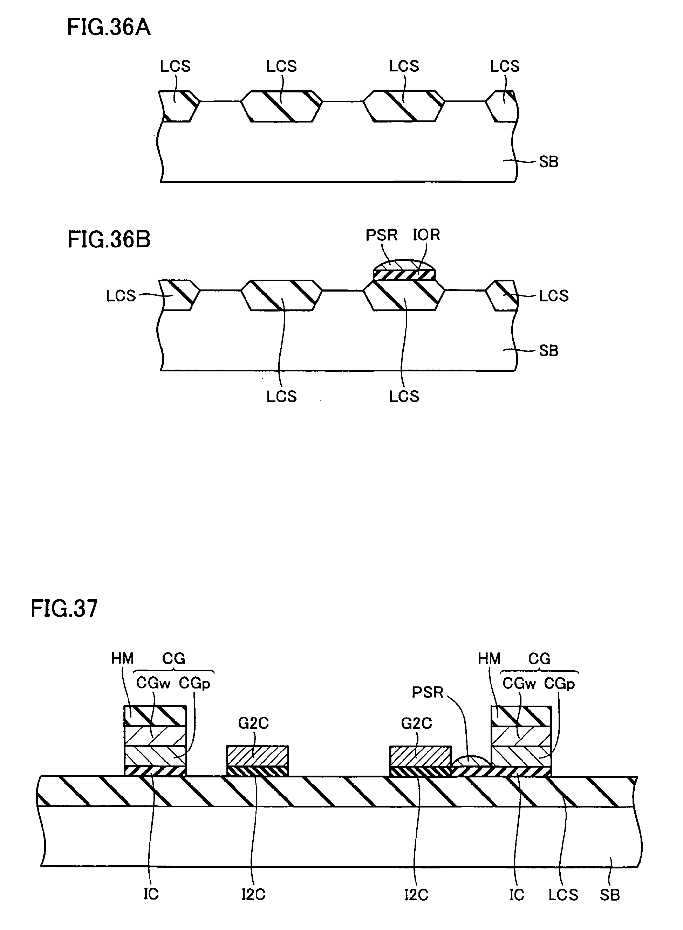

Figs. 36A and 36B are schematic cross-sectional views showing the sixth step in the method of producing the nonvolatile semiconductor memory device of the Comparative Example, wherein the respective cross-sectional positions in Figs. 36A and 36B correspond to the positions along the line XXXIIA-XXXIIA and the line XXXIIB-XXXIIB in Fig. 31, respectively;
Fig. 37 is a schematic cross-sectional view showing the sixth step in the method of producing the nonvolatile semiconductor memory device of the Comparative Example, wherein the cross-sectional position in Fig. 37 corresponds to the position along the line XXXVII-XXXVII in Fig. 24;

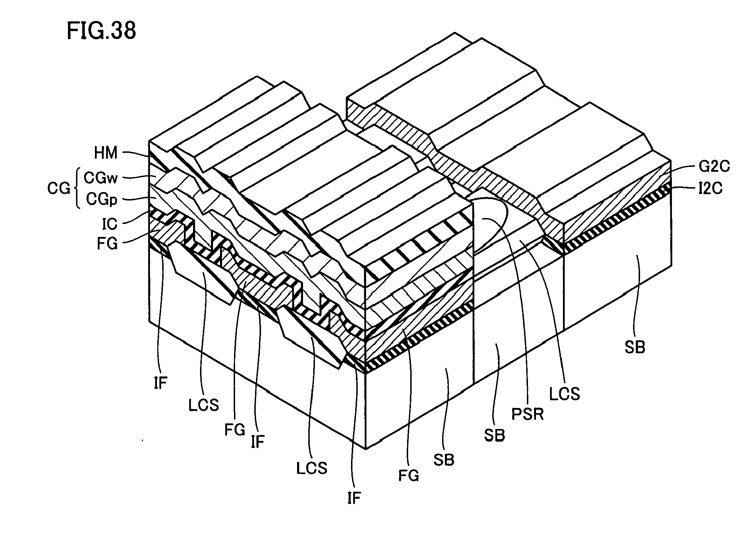

Fig. 38 is a schematic cross-sectional perspective view of a region surrounded by the broken line A in Fig. 24; and

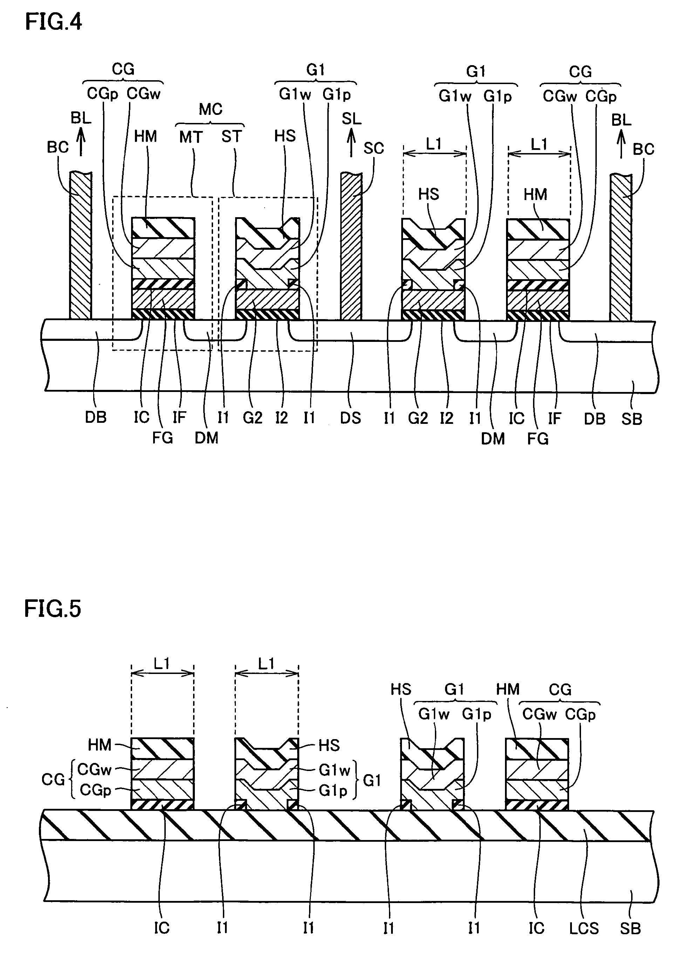

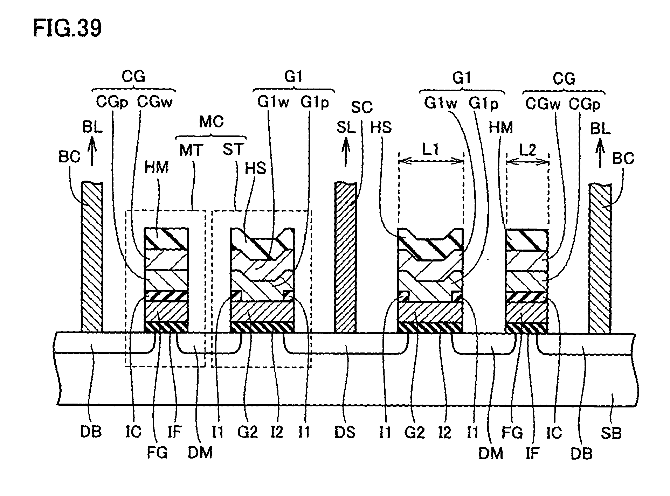

Fig. 39 is a schematic cross-sectional view showing a construction of a nonvolatile semiconductor memory device in the Embodiment 2 of the present invention, wherein the cross-sectional position thereof corresponds to the cross-sectional position in Fig. 4 in the Embodiment 1.

### DESCRIPTION OF THE PREFERRED EMBODIMENTS

Hereafter, preferable embodiments of the present invention will be described with reference to the attached drawings.

### (Embodiment 1)

With reference to Fig. 1, a plurality of memory cells MC are formed by being arranged in a matrix form on a surface of a semiconductor substrate SB which is, for example, a p-type silicon substrate. Each of memory cells MC has a selection transistor ST and a memory transistor MT that are disposed adjacent to each other in the column direction (the longitudinal direction in Fig. 1).

An element isolation layer LCS is formed linearly on the surface of semiconductor substrate SB along a direction crossing the extending direction of an upper gate layer G1. By element isolation layer LCS, selection transistors ST adjacent to each other are separated, and memory transistors MT adjacent to each other are separated.

With reference to Figs. 1 to 4, each of selection transistors ST has a laminate structure made of an upper gate layer G1 and a lower gate layer G2 that is formed to be separated for each one of selection transistors ST. Upper gate layer G1 extends in a row direction (the lateral direction in Fig. 1) along the arrangement of the plurality of selection transistors ST.

An insulating layer I1 (Fig. 4) is formed between lower gate layer G2 and upper gate layer G1. Insulating layer I1 has an opening OP (Fig. 1). At opening OP, lower gate layer G2 and upper gate layer G1 are in direct contact with each other, as shown in Fig. 4. For this reason, upper gate layer G1 is owned by the plurality of selection transistors ST, and is electrically connected to lower gate layer G2 of each of the plurality of selection transistors ST. Also, lower gate layer G2 is insulated from semiconductor substrate SB by an insulating layer I2 (Figs. 2 and 4). Here, a mask HS is formed on upper gate layer G1.

Each of memory transistors MT has a laminate structure made of a control gate CG and a floating gate FG that is formed to be separated for each one of memory transistors MT. Control gate CG is owned by the plurality of memory transistors MT that are arranged in the row direction. Floating gate FG is insulated from control gate CG by an insulating layer IC (Figs. 3 and 4). Also, floating gate FG is insulated from semiconductor substrate SB by an insulating layer IF (Figs. 3 and 4). Here, a mask HM is formed on control gate CG.

Referring mainly to Fig. 4, n-type impurity regions DB, DM, and DS are formed in semiconductor substrate SB.

Lower gate layer G2 of selection transistor ST is located between impurity regions DM and DS, and faces against semiconductor substrate SB via insulating layer 12. Also, since upper gate layer G1 and lower gate layer G2 are short-circuited, upper gate layer G1 functions merely as an interconnect portion. This allows that selection transistor ST can function as a MOS (Metal Oxide Semiconductor) transistor of single-gate type.

Floating gate FG of memory transistor MT is located between impurity regions DM and DB, and faces against semiconductor substrate SB via insulating layer IF. Also, control gate CG and floating gate FG are insulated from each other by insulating layer IC. This allows that memory transistor MT has a construction of a MOS transistor of laminate gate type, whereby information can be stored by control of the accumulated electric charge of floating gate FG.

Within one memory cell MC, selection transistor ST and memory transistor MT commonly owns impurity region DM. This allows that memory cell MC has a structure such that memory transistor MT and selection transistor ST are electrically connected in series.

A bit line contact BC is formed on the upper surface of impurity region DB. Also, a source line contact SC is formed on the upper surface of impurity region DS. This allows that, with regard to memory transistor MT and selection transistor ST constituting one memory cell MC and connected in series, memory transistor MT side is connected to bit line contact BC, and selection transistor ST side is connected to source line contact SC.

Here, bit line contact BC is connected to a bit line BL made of an aluminum interconnect or the like. Also, source line contact SC is connected to a source line SL made of an aluminum interconnect or the like.

With reference to Fig. 6, in the memory cell array, bit lines BL0, BL1, and BL2 are formed as a plurality of bit lines BL that extend in the column direction (the longitudinal direction in Fig. 6). Also, selection lines SLL0, SLL1 and word lines WDL0, WDL1 extending in the row direction (the lateral direction in Fig. 6) are formed. Also, in the memory cell array, a common source line SL is formed.

At bit line BL0, for example, among the plurality of bit lines BL, memory transistor MT side of the plurality of memory cells MC is connected to bit line BLO via bit line contact BC. Two memory cells MC that are adjacent to each other in the column direction (the longitudinal direction in Fig. 6) own source line contact SC that is formed on selection transistor ST side. Source line contact SC is connected to source line SL.

Referring mainly to Fig. 6, word line WDL0, for example, among the plurality of word lines is one control gate CG (Fig. 1) and is owned by the plurality of memory transistors MT that are arranged in the row direction (the lateral direction in Figs. 1 and 6).

Selection line SLL0, for example, among the plurality of selection lines is one upper gate layer G1 (Fig. 1) and is owned by the plurality of selection transistors ST that are arranged in the row direction (the lateral direction in Figs. 1 and 6). This upper gate layer G1 is electrically connected to lower gate layer G2 (Fig. 4) in each of selection transistors ST. For this reason, by setting the voltage level of upper gate layer G1, the voltage level of the plurality of lower gate layers G2 that are electrically connected to this upper gate layer G1 is set. Lower gate layer G2 functions as a selection gate of selection transistor ST. Therefore, by the voltage level of selection line SLL0, the on and off of the plurality of selection transistors ST can be controlled for each row (the arrangement extending laterally in Fig. 6).

Memory cell MC in which selection transistor ST has been turned off will be in a state in which the connection between bit line BL and source line SL is disconnected irrespective of the state of memory transistor MT. Therefore, even if memory transistor MT is in an overerasure state, no adverse effects are produced on the data reading by turning off selection transistor ST that forms a pair.

Here, as shown in Fig. 2, lower gate layer G2 and floating gate FG are formed to have an equal length dimension W in a direction along the extending direction of upper gate layer G1 (the lateral direction in Figs. 1 to 3).

Also, as shown in Fig. 5, lower gate layer G2 and floating gate FG are formed to have an equal length dimension L1 in a direction along the direction crossing upper gate layer G1 (the longitudinal direction in Figs. 1 and 4).

Next, a method of producing a nonvolatile semiconductor memory device in the present embodiment will be described.

With reference to Fig. 7, element isolation layers LCS extending in the same direction and spaced apart from each other with a constant interval are formed, for example, by the LOCOS (Local Oxidation of Silicon) method on a semiconductor substrate SB which is, for example, a p-type silicon substrate.

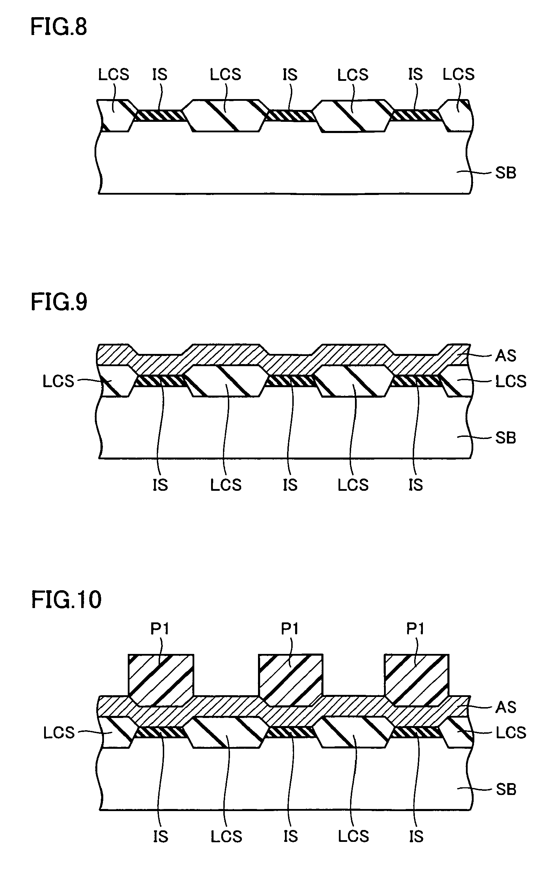

With reference to Fig. 8, an insulating layer (first insulating layer) IS is formed, for example, by the thermal oxidation method on the upper surface of semiconductor substrate SB.

With reference to Fig. 9, an electroconductive layer (first electroconductive layer) AS made, for example, of amorphous silicon to which an impurity has been added is formed on semiconductor substrate SB.

With reference to Fig. 10, a photoresist P 1 having a linear opening is formed by the photolithography method along the regions sandwiched between element isolation layers LCS. Photoresist P1 contains an acid component.

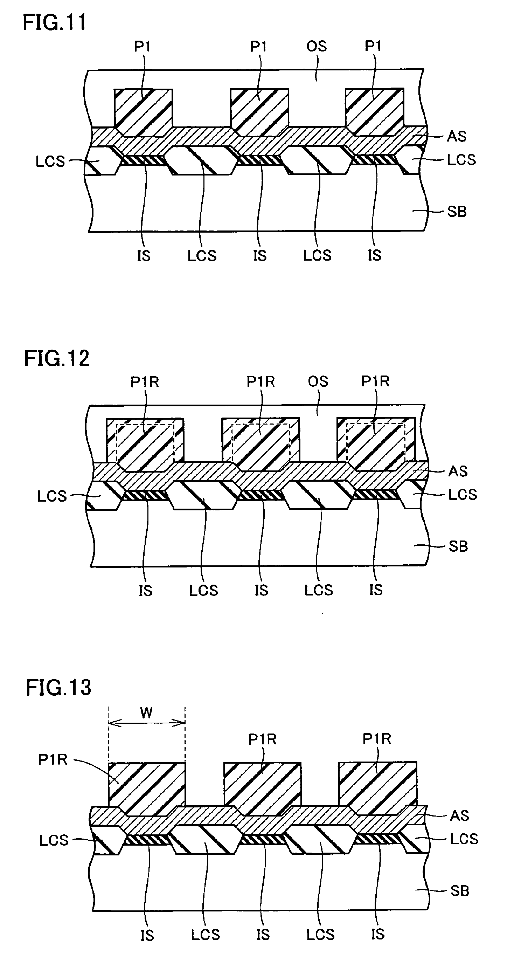

With reference to Fig. 11, a water-soluble upper layer agent OS is applied on semiconductor substrate SB so as to cover photoresist P1. Water-soluble upper layer agent OS has a property of being cured by acting with an acid at a high temperature.

With reference to Fig. 12, semiconductor substrate SB is subjected to a heating process. By this process, a part of water-soluble upper layer agent OS is cured by acting with the acid contained in photoresist P1 (broken line part in Fig. 12) at the interface between photoresist P1 (broken line part in Fig. 12) and water-soluble upper layer agent OS. This cured substance will form a photoresist P1R by being integrated with photoresist P1 (broken line part in Fig. 12).

With reference to Fig. 13, the uncured part of water-soluble upper layer agent OS is removed. By this, photoresist P1R is obtained having an opening smaller by the adhering amount of the above-described cured substance than photoresist P1 of Fig. 10. Photoresist P1R has a width dimension W in a direction crossing the extending direction of element isolation layers LCS (the lateral direction in Fig. 13), and extends linearly along the extending direction of element isolation layers LCS. Therefore, the opening of photoresist P1R extends linearly along the extending direction of element isolation layers LCS.

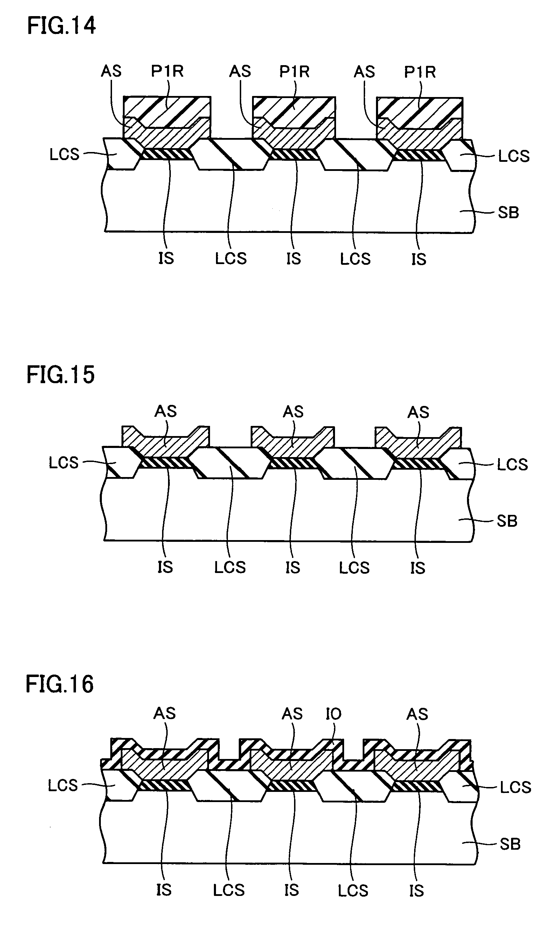

With reference to Fig. 14, electroconductive layer AS is patterned (first patterning step) by etching with use of resist P1R as a mask. Subsequently, resist P1R is removed.

Referring mainly to Fig. 15, by the above-described patterning step, electroconductive layer AS is formed having a pattern crossing over a part between element isolation layers LCS and going in the extending direction of element isolation layers LCS. This pattern of electroconductive layer AS includes a plurality of floating gates FG and lower gate layers G2 along the column direction (the longitudinal direction in Fig. 1). Namely, this pattern extends in a band shape over the region where a plurality of memory cells are formed along the column direction (the longitudinal direction in Fig. 1).

With reference to Fig. 16, an insulating layer 10 (second insulating layer) made, for example, of ONO (Oxide Nitride Oxide) is formed over the entire surface of semiconductor substrate SB.

Referring mainly to Figs. 17A to 17C, a photoresist P2 is selectively formed by the photolithography method on semiconductor substrate SB. The plurality of openings of photoresist P2 correspond to the positions of openings OP in Fig. 1. Subsequently, with use of photoresist P2 as a mask, insulating layer IO is patterned by etching. Subsequently, photoresist P2 is removed.

Referring mainly to Figs. 18A to 18C, by the above-described step of patterning insulating layer IO, the surface of electroconductive layer AS is exposed at the positions of the plurality of openings OP of insulating layer IO (Fig. 1). Opening OP is formed to extend in a direction crossing the extending direction of the band shape formed in Fig. 15.

With reference to Figs. 19A to 19C, an electroconductive layer (second electroconductive layer) PS, for example, having a thickness of 100 to 130 nm and made of polysilicon to which an impurity has been added is formed over the entire surface of semiconductor substrate SB. Subsequently, an electroconductive layer WS, for example, having a thickness of 70 to 100 nm and made of tungsten silicide is formed, for example, by the CVD method. Subsequently, a hard mask layer HD which is, for example, a silicon oxide film having a thickness of 180 to 220 nm is formed. As a method for forming this, one can use, for example, the CVD method using TEOS (Tetra Ethyl Ortho Silicate) as a starting material.

Referring mainly to Figs. 20A to 20C, a photoresist P3 is selectively formed on the above-described hard mask layer HD. The region where photoresist P3 is formed is a region where control gate CG and upper gate layer G1 are formed in Fig. 1. Subsequently, with use of photoresist P3, hard mask layer HD is patterned. Thereafter, photoresist P3 is removed.

Referring mainly to Figs. 21A to 21C, by imparting a pattern to hard mask layer HD by the above-described patterning step, a mask HS and a mask HM are formed. Mask HS is formed in a region where upper gate layer G1 is formed in Fig. 1. Mask HM is formed in a region where control gate CG is formed in Fig. 1. Subsequently, with use of masks HS, HM as a mask, the unmasked region is etched down to semiconductor substrate SB surface (second patterning step).

With reference to Figs. 22A to 22C, two kinds of stack gate structures are formed by the above-described etching step with use of masks HS, HM.

One stack gate structure (the stack structure at both ends of Fig. 22C) is formed by lamination of insulating layer IF, floating gate FG, insulating layer IC, an electroconductive layer CGp, an electroconductive layer CGw, and mask HM in this order on semiconductor substrate SB. Electroconductive layer CGp and electroconductive layer CGw together form control gate CG. Floating gate FG and control gate CG are insulated from each other by insulating layer IC.

The other stack gate structure (the two stack structures located in the middle of Fig. 22C) is formed by lamination of insulating layer 12, lower gate layer G2, insulating layer I1, an electroconductive layer G1p, an electroconductive layer G1w, and mask HS in this order on semiconductor substrate SB. Insulating layer I1 has an opening in a region corresponding to opening OP of Fig. 1. For this reason, upper gate layer G1 and lower gate layer G2 are electrically connected with each other at this opening.

With reference to Figs. 23A to 23C, ion implantation is made into semiconductor substrate SB. During this step, masks HM and HS serve as a mask. This forms n-type impurity regions DB, DM, and DS in the upper surface of semiconductor substrate SB.

With reference to Fig. 4, an interlayer insulating layer (not illustrated in the drawings) is formed, and bit line contact BC and source line contact SC are formed in this interlayer insulating layer. Bit line contact BC is connected to bit line BL, and source contact SC is connected to source line SL. By the above process, a nonvolatile semiconductor memory device of the present embodiment is produced.

With reference to Figs. 24, 25, and 27, selection transistor STC has a gate layer G2C that extends over a plurality of selection transistors STC in the row direction (the lateral direction in Figs. 24 and 25) as the gate electrode thereof. Gate layer G2C is insulated from semiconductor substrate SB by an insulating layer 12C.

The construction of the present Comparative Example other than the above is almost similar to the construction of the above-described Embodiment 1, so that the description thereof will be omitted by denoting identical elements with identical symbols.

In the present Comparative Example, due to poor production, an electroconductive substance remains in a gate-to-gate region R (Fig. 24) which is a region between gate layer G2C and control gate CG on element isolation layer LCS, whereby poor production is liable to occur in which gate layer G2C and control gate CG are short-circuited.

The production steps that generate this poor production will be described as follows. Here, up to the production step shown in Fig. 9, the production steps of the present Comparative Example and the production steps of the present embodiment are the same, so that the steps subsequent thereto will be described.

Referring mainly to Figs. 29 and 30, a photoresist P1C is selectively formed with use of the photolithography method on the upper surface of electroconductive layer AS (Fig. 9) formed on semiconductor substrate SB.

At this time, unlike the above-described present embodiment, in the present Comparative Example, photoresist P1C is formed also on the part (a part C shown in Fig. 29) that overrides element isolation layer LCS. For this reason, the opening of photoresist P1C (the surface where electroconductive layer AS is exposed) will not be linear, and has a plurality of end parts E.

Here, as shown in Fig. 29, the position of end part E coincides with the position of region R (Fig. 24) between the gates.

Subsequently, in the manner similar to the steps of Figs. 11 to 13 in the above-described present embodiment, water-soluble upper layer agent OS is applied and cured, followed by removal of uncured water-soluble upper layer agent OS. This diminishes the opening of photoresist P1C.

Referring mainly to Figs. 31, 32A, and 32B, by the above-described step of diminishing the opening, a photoresist P1RC is formed having an opening smaller than that of photoresist P1C (the broken line part in the drawings). This opening extends largely in a circular shape at an end part ER rather than at the middle part, as shown in Fig. 31. This is because water-soluble upper layer agent OS is hardly applied on end part E (Fig. 29) of the opening of photoresist P1C (Fig. 29), so that the function of diminishing the opening will be smaller at end part E (Fig. 29).

Subsequently, with photoresist P1RC used as a mask, an etching process is carried out so as to pattern electroconductive layer AS. Thereafter, photoresist P1RC is removed.

Here, as shown in Fig. 31, the position of end part ER coincides with the position of region R (Fig. 24) between the gates.

Referring mainly to Figs. 33A and 33B, by the above-described patterning step, the pattern of electroconductive layer AS is formed. The dimension of electroconductive layer AS in the direction crossing element isolation layer LCS (the lateral direction in the drawings) is smaller in Fig. 33B than in Fig. 33A. This is because the cross-sectional position in Fig. 33B is located at end part ER (Fig. 31) of the opening of photoresist P1RC.

With reference to Figs. 34A and 34B, insulating layer 10 is formed so as to cover electroconductive layer AS. A recess of insulating layer 10 is formed between the pattern of adjacent electroconductive layers AS. The width dimension of this recess is Wa in Fig. 34A and is Wb in Fig. 34B. Between the two dimensions, a relationship of Wa < Wb holds.

Referring mainly to Figs. 35A and 35B, electroconductive layers PS, WS and hard mask layer HD are formed on insulating layer IO. The formation of these films is carried out also on the above-described recess of insulating layer IO. For this reason, in the part located in the middle part of the opening of photoresist P1RC, recesses Sal, Sa2 (Fig. 35A) are formed respectively in hard mask layer HD and in electroconductive layer WS. Also, in the part located at end part ER (Fig. 31) of the opening of photoresist P1RC, recesses Sb1, Sb2 (Fig. 35B) are formed respectively in hard mask layer HD and in electroconductive layer WS.

Recess Sb2 is a recess larger than recess Sa2. Also, recess Sb1 is a recess larger than recess Sa1. In such large recesses, foreign substances DST made of photoresist, oxide film, or the like are liable to remain. In the following, a case will be described in which foreign substances DST (Fig. 35B) remain.

By a method similar to that of the above-described present embodiment (Figs. 20A to 20C), a patterning step is carried out on hard mask layer HD, so as to form a desired mask. Next, with use of this mask, an etching process is carried out for forming a laminate pattern of memory transistor MT part.

With reference to Figs. 36A and 36B, when the step of forming a laminate pattern of above-described memory transistor MT part is normally carried out, an etching process is carried out so as to expose the upper surface of element isolation layer LCS in both of Figs. 36A and 36B. However, since foreign substances DST (Fig. 35B) functions as a mask for etching, a layer that has not been subjected to the etching process will remain at some parts on element isolation layer LCS. Namely, an insulating layer IOR which is a residual of insulating layer 10 and an electroconductive layer PSR which is a residual of electroconductive layer PS will remain.

Electroconductive layer PSR is located in region R between the gates in Fig. 24. In this case, the cross section along the line XXXVII-XXXVII in Fig. 24 will be as in Fig. 37, whereby electroconductive layer PSR will generate a short circuit between gate layer G2C and control gate CG.

Here, the position of electroconductive layer PSR is shown also in Fig. 38.

According to the present embodiment, selection transistor ST has two gate layers made of an upper gate layer G1 and lower gate layer G2, as shown in Fig. 1. Also, upper gate layer G1 is owned commonly by a plurality of selection transistors. Also, at the part of opening OP, upper gate layer G1 and lower gate layer G2 are electrically connected with each other as shown in Fig. 4. For this reason, even if lower gate layer G2 is separated for each one of selection transistors ST, the electric potential of the plurality of lower gate layers G2 can be controlled by controlling the electric potential of one upper gate layer G1.

Also, since lower gate layer G2 is separated for each one of the selection transistors as described above, the opening of photoresist P1R for patterning electroconductive layer AS can be formed to extend linearly along the extending direction of element isolation layer LCS (the direction perpendicular to the document sheet), as shown in Fig. 13. Therefore, a shape with a widened opening such as end part ER of the opening of photoresist P1RC shown in Fig. 31 constituting the Comparative Example will not be generated.

As a result of this, the recesses in the upper surfaces of hard mask layer HD and electroconductive layer WS shown in Fig. 19B, for example, are formed uniformly over the entire surface. Namely, locally large recesses Sb1, Sb2 such as shown in Fig. 35B constituting the Comparative Example are not formed.

Therefore, foreign substances DST can be restrained from remaining in the recessed parts. For this reason, one can restrain a state in which foreign substances DST function as a mask at the time of etching electroconductive layer PS and electroconductive layer PSR (Fig. 37) which is a part of electroconductive layer PS remains at the position corresponding to region R (Fig. 24) between the gates in the Comparative Example. As a result of this, one can restrain the generation of poor products in which the region between lower gate layer G2 and control gate CG on element isolation layer LCS is short-circuited.

Also, photoresist P1R (Fig. 13) is formed by applying water-soluble upper layer agent OS (Fig. 11) on photoresist P1 (Fig. 10), and curing a part of water-soluble upper layer agent OS (Fig. 12). As a result of this, the dimension of the opening of the mask for etching is made fine. Unlike photoresist P1C (Fig. 29), this photoresist P 1 does not have a part C (Fig. 29) that overrides element isolation layer LCS. For this reason, water-soluble upper layer agent OS can be applied uniformly over the entire surface. Therefore, one can prevent the shape of end part ER of the opening of the mask from becoming larger than the midway part thereof as shown in Fig. 31.

Also, lower gate layer G2 of selection transistor ST and floating gate FG which is the gate layer on the lower side of memory transistor MT are simultaneously formed by the patterning on electroconductive layer AS (Fig. 9) formed over the entire surface on semiconductor substrate SB. This can simplify the production steps as compared with a case in which lower gate layer G2 and floating gate FG are separately formed.

Also, upper gate layer G1 of selection transistor ST and control gate CG which is the gate layer on the upper side of memory transistor MT are simultaneously formed by the patterning on electroconductive layers PS, WS (Figs. 19A to 19C) formed over the entire surface on semiconductor substrate SB. This can simplify the production steps as compared with a case in which upper gate layer G1 and control gate CG are separately formed.

Also, as shown in Fig. 4, lower gate layer G2 and upper gate layer G1 are electrically connected with each other by being in direct contact. For this reason, there is no need to form a film separately for electrically connecting lower gate layer G2 and upper gate layer G1 with each other.

Also, as shown in Figs. 2 and 3, lower gate layer G2 and floating gate FG have an identical length dimension W along the extending direction of upper gate layer G1 (the lateral direction in the drawings). For this reason, lower gate layer G2 and floating gate FG can be patterned by linear photoresist P1R having a pattern width of W, as shown in Fig. 13.

Also, as shown in Fig. 1, element isolation layer LCS is formed linearly on semiconductor substrate SB along a direction crossing the extending direction of upper gate layer G1. For this reason, in the step of patterning for separating electroconductive layer AS on element isolation layer LCS, photoresist P1R (Fig. 13) constituting the mask also can be formed linearly.

### (Embodiment 2)

With reference to Fig. 39, the construction of the present embodiment is different from the construction of the Embodiment 1 in that the dimension of floating gate FG is different. Namely, the length dimension of floating gate FG in the direction (the lateral direction in Fig. 39) crossing in the extending direction of upper gate layer G1 is L2, which is a dimension smaller than length dimension L1 of lower gate layer G2.

Selection transistor ST has a complex structure in which two gate layers are in contact with each other in the opening disposed in the insulating layer between the two. On the other hand, memory transistor MT has a simple stack structure. For this reason, memory transistor MT can be miniaturized more easily than selection transistor ST, and the dimension thereof can be made smaller than that of selection transistor ST.

Here, the construction of the present embodiment other than those described above is approximately similar to the construction of the above-described Embodiment 1, so that the description thereof will be omitted by denoting identical elements with identical symbols.

According to the present embodiment, the length of floating gate FG will be smaller than the length of lower gate layer G2, as shown in Fig. 39. This reduces the scale of memory transistor MT. Therefore, the memorizing capacity per unit area of the apparatus can be increased.

Although the present invention has been described and illustrated in detail, it is clearly understood that the same is by way of illustration and example only and is not to be taken by way of limitation, the scope of the present invention being interpreted by the terms of the appended claims.

## Claims

1. A nonvolatile semiconductor memory device comprising:
a semiconductor substrate (SB) having a principal surface;
a plurality of memory transistors (MT), each of said plurality of memory transistors (MT) having a floating gate (FG) and a control gate (CG), said floating gate (FG) and said control gate (CG) being formed by lamination with each other on said principal surface; and
a plurality of selection transistors (ST), each of said plurality of selection transistors (ST) having a lower gate layer (G2) and an upper gate layer (G1), said lower gate layer (G2) and said upper gate layer (G1) being formed by lamination with each other on said principal surface, each of said plurality of selection transistors (ST) contained in a memory cell (MC) together with one of said plurality of memory transistors (MT), wherein
said lower gate layer (G2) is separated for each of said plurality of selection transistors (ST), and
said upper gate layer (G1) is owned commonly by said plurality of selection transistors (ST) and is electrically connected to said lower gate layer (G2) of each of said plurality of selection transistors (ST).

2. The nonvolatile semiconductor memory device according to claim 1, wherein said upper gate layer (G1) is directly connected to said lower gate layer (G2).

3. The nonvolatile semiconductor memory device according to claim 1 or 2, wherein said lower gate layer (G2) and said floating gate (FG) have an identical length along an extending direction of said upper gate layer (G1).

4. The nonvolatile semiconductor memory device according to one of claims 1 to 3, wherein a length of said floating gate (FG) is shorter than a length of said lower gate layer (G2) along a direction crossing an extending direction of said upper gate layer (G1).

5. The nonvolatile semiconductor memory device according to one of claims 1 to 4, further comprising an element isolation layer (LCS) that is formed linearly on said semiconductor substrate (SB) along a direction crossing an extending direction of said upper gate layer (G1).

6. A method of producing a nonvolatile semiconductor memory device having a plurality of memory cells (MC), the method comprising the steps of:
forming a first insulating layer (IS) on a semiconductor substrate (SB);
forming a first electroconductive layer (AS) on said first insulating layer (IS);
patterning said first electroconductive layer (AS) into a plurality of band shapes, each of said band shapes extending over a region where said plurality of memory cells (MC) are to be formed;
forming a second insulating layer (10) on said first electroconductive layer (AS);
forming a plurality of openings (OP) exposing a surface of said first electroconductive layer (AS) in said second insulating layer (10), each of said plurality of openings (OP) crossing said plurality of band shapes;
forming a second electroconductive layer (PS) so as to be electrically connected to said first electroconductive layer (AS) via said openings (OP) and to cover said second insulating layer (IO) ; and
patterning said second electroconductive layer (PS) and said first electroconductive layer (AS) so as to form a laminate pattern including a part of said first electroconductive layer (AS) and a part of said second electroconductive layer (PS) that are electrically insulated with each other by said second insulating layer (10), and to form a laminate pattern including a part of said first electroconductive layer (AS) and a part of said second electroconductive layer (PS) that are formed along said openings (OP) and electrically connected with each other at said openings (OP).

7. The method of producing the nonvolatile semiconductor memory device according to claim 6, wherein said step of patterning said first electroconductive layer (AS) includes a step of forming a mask (P1R) having a linear opening.

8. The method of producing the nonvolatile semiconductor memory device according to claim 6 or 7, wherein said step of patterning said first electroconductive layer (AS) includes the steps of:
forming a resist pattern (P1);
applying a liquid material (OS) so as to bury an opening of said resist pattern (P1) ; and
removing an uncured part of said liquid material (OS) after curing a part of said liquid material (OS) at an interface with said resist pattern (P1).
